# EUROPEAN PATENT APPLICATION

(11) **EP 4 462 242 A1**
(43) Date of publication of application: **13.11.2024**
(21) Application number: 23752245.3
(22) Date of filing: 18.01.2023
(51) Int. Cl.: G06F 3/06

(54) **METHOD FOR ADJUSTING SPECIFICATION PARAMETER OF SSD AND RELATED PRODUCT**

(30) Priority: 09.02.2022 CN 202210122757
(71) Applicant: Huawei Cloud Computing Technologies Co., Ltd., Guiyang, Guizhou 550025 (CN)
(72) Inventor: XU, Jie, Guiyang, Guizhou 550025 (CN); ZHOU, Jianhua, Guiyang, Guizhou 550025 (CN); HYUN, Jea Woong, Guiyang, Guizhou 550025 (CN); YU, Zhou, Guiyang, Guizhou 550025 (CN); CHEN, Lv, Guiyang, Guizhou 550025 (CN)
(74) Representative: Isarpatent
(86) International application number: PCT/CN2023/072946
(87) International publication number: WO 2023/151465

(57) **Abstract**

Embodiments of this application provide a method for adjusting a specification parameter of an SSD and a related product, to adjust the specification parameter of the SSD, improve resource utilization of the SSD, and reduce occurrence of an SSD resource shortage or resource waste. The method for adjusting a specification parameter of an SSD includes: The SSD receives a configuration command through an internal configuration interface, where a current specification parameter of the SSD is a first specification parameter, and the configuration command includes representation information of a second specification parameter; and then the SSD adjusts the specification parameter of the SSD from the first specification parameter to the second specification parameter based on the configuration command.

## Description

This application claims priority to Chinese Patent Application No. 202210122757.2, filed with the China National Intellectual Property Administration on February 9, 2022 and entitled "METHOD FOR ADJUSTING SPECIFICATION PARAMETER OF SSD AND RELATED PRODUCT", which is incorporated herein by reference in its entirety.

### TECHNICAL FIELD

Embodiments of this application relate to the field of storage technologies, and in particular, to a method for adjusting a specification parameter of a solid-state drive (solid-state drive, SSD) and a related product.

### BACKGROUND

A solid-state drive (solid-state drive, SSD) has many advantages such as a high read/write speed, low power consumption, and strong environment adaptability, and therefore is widely used. For example, the solid-state drive is deployed in a distributed storage system as a cache, or deployed in a server as a storage device. Generally, before the SSD is deployed, an SSD with an appropriate specification parameter (including drive writes per day (drive writes per day, DWPD) and data retention (retention)) is first selected based on a use scenario. However, as a service changes, the previously selected SSD may fail to meet a subsequent service requirement, resulting in a resource shortage or resource waste.

### SUMMARY

Embodiments of this application provide a method for adjusting a specification parameter of an SSD and a related product, to dynamically adjust the specification parameter of the SSD with a change of a service requirement. An adjusted SSD better meets a future service requirement. This reduces occurrence of a resource shortage or resource waste.

According to a first aspect, an embodiment of this application provides a method for generating a specification parameter of an SSD. The method includes: A configuration apparatus collects running status information of the SSD, where the running status information indicates a running status of the SSD, and a current specification parameter of the SSD is a first specification parameter; and then the configuration apparatus generates a configuration command based on the running status information, and sends the configuration command to the SSD, where the configuration command includes representation information of a second specification parameter.

According to the method provided in the first aspect, the specification parameter of the SSD may be generated based on the running status information of the SSD, and after the generated specification parameter is sent to the SSD, the SSD may be instructed to adjust the specification parameter of the SSD. In addition, because the collected running status information of the SSD can indicate a future service requirement to some extent, in comparison with the first specification parameter, the second specification parameter better meets the future service requirement. Therefore, an adjusted SSD better meets the future service requirement. This can reduce occurrence of a resource shortage or resource waste.

In a possible implementation of the first aspect, the specification parameter of the SSD includes at least one of DWPD, data retention, a P/E count, and a capacity of over provisioning (over provisioning, OP).

In a possible implementation of the first aspect, that the configuration apparatus generates a configuration command based on the running status information includes: The configuration apparatus determines a future service requirement for the specification parameter of the SSD based on the running status information, and then generates the configuration command based on the future service requirement for the specification parameter of the SSD, where the second specification parameter meets the future service requirement. In this way, an adjusted SSD can better meet the future service requirement.

In a possible implementation of the first aspect, the configuration apparatus includes a plurality of levels, and each level includes a correspondence between at least two parameters of the DWPD, the data retention, and the P/E count.

In a possible implementation of the first aspect, the representation information of the second specification parameter includes a target level, and that the configuration apparatus generates the configuration command based on the future service requirement for the specification parameter of the SSD includes: The configuration apparatus determines the target level from the plurality of levels based on the future service requirement for the specification parameter of the SSD, and generates the configuration command based on the target level. In this way, workload of the configuration apparatus can be reduced, and a rate at which the configuration apparatus generates the configuration command can be increased.

In a possible implementation of the first aspect, the representation information of the second specification parameter further includes a capacity of target OP, and that the configuration apparatus determines the target level from the plurality of levels based on the future service requirement for the specification parameter of the SSD includes: The configuration apparatus determines, based on the future service requirement for the specification parameter of the SSD, that at least two levels meet the future service requirement. In this case, the configuration apparatus determines that a level corresponding to maximum DWPD is the target level. The method further includes: The configuration apparatus reduces a capacity of current OP in the SSD based on the maximum DWPD, to obtain the capacity of the target OP. That the configuration apparatus generates the configuration command based on the target level includes: The configuration apparatus generates the configuration command based on the target level and the capacity of the target OP. In this way, an available capacity of the SSD can be increased, and costs can be reduced.

According to a second aspect, an embodiment of this application provides a method for adjusting a specification parameter of an SSD, where a current specification parameter of the SSD is a first specification parameter, and the method includes: The SSD receives a configuration command through an internal configuration interface, where the configuration command includes representation information of s second specification parameter; and then the SSD adjusts the specification parameter of the SSD from the first specification parameter to the second specification parameter based on the configuration command. The method is implemented, so that the specification parameter of the SSD can be adjusted, and resource utilization of the SSD can be improved, thereby reducing occurrence of an SSD resource shortage or resource waste.

In a possible implementation of the second aspect, the specification parameter of the SSD includes at least one of DWPD, data retention, a P/E count, and a capacity of OP.

In a possible implementation of the second aspect, the second specification parameter meets a future service requirement. In this way, an adjusted SSD can better meet the future service requirement, to reduce the occurrence of the SSD resource shortage or resource waste.

In a possible implementation of the second aspect, the SSD stores a plurality of levels, and each level includes a correspondence between at least two parameters of the DWPD, the data retention, and the P/E count.

In a possible implementation of the second aspect, the representation information of the second specification parameter includes a target level, and that the SSD adjusts the specification parameter of the SSD from the first specification parameter to the second specification parameter based on the configuration command includes: The SSD matches the target level with the plurality of levels, to determine a specification parameter corresponding to the target level, where the second specification parameter includes the specification parameter corresponding to the target level; and then the SSD adjusts the specification parameter of the SSD from the first specification parameter to the specification parameter corresponding to the target level. In this way, efficiency of adjusting the specification parameter of the SSD by the SSD can be improved.

In a possible implementation of the second aspect, the representation information of the second specification parameter includes a capacity of target OP. In this way, an available capacity of the SSD can be increased, utilization of the SSD can be improved, and costs can be reduced.

According to a third aspect, an embodiment of this application provides a configuration apparatus. The apparatus includes: a data collection module, configured to collect running status information of an SSD, where the running status information indicates a running status of the SSD, and a current specification parameter of the SSD is a first specification parameter; a data analysis module, configured to generate a configuration command based on the running status information, where the configuration command includes representation information of a second specification parameter; and a configuration module, configured to send the configuration command to the SSD.

In a possible implementation of the third aspect, the specification parameter of the SSD includes at least one of DWPD, data retention, a P/E count, and a capacity of OP.

In a possible implementation of the third aspect, the data analysis module is configured to: determine a future service requirement for the specification parameter of the SSD based on the running status information, and generate the configuration command based on the future service requirement for the specification parameter of the SSD, where the second specification parameter meets the future service requirement.

In a possible implementation of the third aspect, the configuration apparatus includes a plurality of levels, and each level includes a correspondence between at least two parameters of the DWPD, the data retention, and the P/E count.

In a possible implementation of the third aspect, the representation information of the second specification parameter includes a target level, and the data analysis module is configured to: determine a target level from the plurality of levels based on the future service requirement for the specification parameter of the SSD, and generate the configuration command based on the target level.

In a possible implementation of the third aspect, the representation information of the second specification parameter further includes a capacity of target OP, and the data analysis module is configured to: determine, based on the future service requirement for the specification parameter of the SSD, that at least two levels meet the future service requirement, and determine a level corresponding to maximum DWPD as the target level. The data analysis module is further configured to: reduce a capacity of current OP in the SSD based on the maximum DWPD, to obtain the capacity of the target OP. The data analysis module is configured to generate the configuration command based on the target level and the capacity of the target OP.

According to a fourth aspect, an embodiment of this application provides an SSD, where a current specification parameter of the SSD is a first specification parameter, and the SSD includes: a configuration interface, configured to receive a configuration command, where the configuration command includes representation information of a second specification parameter; and a controller, configured to adjust the specification parameter of the SSD from the first specification parameter to the second specification parameter based on the configuration command.

In a possible implementation of the fourth aspect, the specification parameter of the SSD includes at least one of drive writes per day DWPD, data retention, a program/erase P/E count, and a capacity of over provisioning OP.

In a possible implementation of the fourth aspect, the second specification parameter meets a future service requirement.

In a possible implementation of the fourth aspect, the SSD stores a plurality of levels, and each level includes a correspondence between at least two parameters of the DWPD, the data retention, and the P/E count.

In a possible implementation of the fourth aspect, the representation information of the second specification parameter includes a target level, and the controller is configured to: match the target level with the plurality of levels, to determine a specification parameter corresponding to the target level, where the second specification parameter includes the specification parameter corresponding to the target level; and adjust the specification parameter of the controller from the first specification parameter to the specification parameter corresponding to the target level.

In a possible implementation of the fourth aspect, the representation information of the second specification parameter includes a capacity of target OP.

According to a fifth aspect, an embodiment of this application provides an adjustment system, including the configuration apparatus described in the first aspect or any implementation of the first aspect, and the SSD described in the second aspect or any implementation of the second aspect. The configuration apparatus is configured to: collect running status information of the SSD, generate a configuration command based on the running status information, and send the configuration command to the SSD, where the configuration command includes representation information of a second specification parameter. The SSD is configured to: receive the configuration command through an internal configuration interface, and adjust a specification parameter of the SSD from a first specification parameter to the second specification parameter based on the configuration command.

The specification parameter of the SSD can be adjusted by using the foregoing adjustment system. In addition, because the adjustment system can adjust the specification parameter of the SSD based on a future service requirement, an adjusted SSD better meets the future service requirement, especially when a service requirement changes dynamically with time. By using the foregoing adjustment system, utilization of the SSD can be further improved, and occurrence of a resource shortage or resource waste can be reduced.

According to a sixth aspect, an embodiment of this application provides a computing device. The computing device includes a processor and a storage, and the processor executes computer program code in the storage to implement some or all of the methods described in the first aspect and any implementation of the first aspect.

According to a seventh aspect, an embodiment of this application provides a computer-readable storage medium. The computer storage medium stores computer program code, and when the computer program code is executed by a computing device, the computing device performs some or all of the methods described in the first aspect and any implementation of the first aspect.

### BRIEF DESCRIPTION OF DRAWINGS

FIG. 1 is a diagram of a structure of an adjustment system according to an embodiment of this application;
FIG. 2 is a diagram of a structure of a distributed storage system according to an embodiment of this application;
FIG. 3 is a diagram of deployment of an adjustment system according to an embodiment of this application;
FIG. 4 is a diagram of an application scenario of an adjustment system according to an embodiment of this application;
FIG. 5 is a diagram of a structure of a centralized storage system according to an embodiment of this application;
FIG. 6 is a diagram of deployment of another adjustment system according to an embodiment of this application;
FIG. 7 is a diagram of an application scenario of another adjustment system according to an embodiment of this application;
FIG. 8 is a diagram of a method for adjusting a specification parameter of an SSD according to an embodiment of this application;
FIG. 9 is a diagram of a structure of a configuration apparatus according to an embodiment of this application;
FIG. 10 is a diagram of a structure of an SSD according to an embodiment of this application;
FIG. 11 is a diagram of a structure of a computing device according to an embodiment of this application; and
FIG. 12 is a diagram of a structure of a computing device system according to an embodiment of this application.

### DESCRIPTION OF EMBODIMENTS

To make solutions provided in embodiments of this application clearer, before the solutions provided in embodiments of this application are specifically described, related terms in embodiments of this application are first described.

An SSD is a storage device that mainly uses a flash memory chip as a storage medium, and has advantages such as a high read/write speed, low power consumption, and strong environment adaptability. However, at the same time, a limitation of the flash memory chip also affects a service life of the SSD. This is because the flash memory chip uses a floating-gate (floating-gate, FG) field-effect transistor to store data, and each transistor of this type is also referred to as a cell (cell). Each transistor indicates written data by adjusting an amount of electron charge stored on an internal FG. For example, when the amount of electron charge stored on the FG is higher than a threshold A, it indicates that the written data is 0; or when the amount of electron charge stored on the FG is lower than a threshold A, it indicates that the written data is 1. When the data stored on the transistor is erased, an oxide layer in the transistor is destroyed, and a capability of blocking an electron loss by the oxide layer is reduced. This reduces the amount of electron charge stored on the FG in a case of a power failure. When an excessive amount of electron charge stored on the FG is reduced, an error may occur when the data is read. For example, when the written data is 0, it indicates that the amount of electron charge stored on the FG is higher than the threshold A when the data is written. However, due to severe wear of the oxide layer in the transistor, the amount of electron charge stored on the FG is gradually reduced after a time period until the amount is lower than the threshold A. As a result, the read data becomes 1. In general, a larger quantity of times of an erase operation performed on the SSD indicates a weaker data storage capability of the SSD, and a higher probability of an error occurring in data stored in the SSD. When a data error rate exceeds a threshold B, it means that the service life of the SSD ends.

Parameters for measuring the service life of the SSD include a program/erase (program/erase, P/E) count and drive writes per day (drive writes per day, DWPD). The P/E count is a quantity of times of a P/E operation performed on the SSD, and one time of the P/E operation is performing one time of a data erase operation (referred to as the erase operation for short below) in a unit of a block (block) after performing at least one time of a data write operation on the SSD in a unit of a page (page). It should be noted that, if a block includes both valid data and invalid data (namely, data that needs to be deleted from the SSD), this part of valid data and valid data in another block need to be combined first, and rewritten into a new block, so that all the data in the original block can be erased for new data to be written. This process is also referred to as garbage collection. DWPD is a quantity of times of a drive write operation performed on the SSD every day. The DWPD is in direct proportion to the P/E count. More DWPD and a larger P/E count indicate a weaker data storage capability of the SSD and shorter data retention (retention) of the SSD in the case of the power failure. The data retention is a time period in which the SSD can store data when the SSD is powered off. In this time period, the data stored in the SSD can be correctly read.

It is considered that different scenarios may have different requirements on the P/E count, the DWPD, and the data retention of the SSD. Therefore, before the SSD is deployed, an SSD with an appropriate specification parameter (for example, the P/E count, the DWPD, and the data retention) is first selected based on an application scenario. For example, a DWPD specification of a conventional enterprise-level SSD includes two types: one DWPD and three DWPD. When a large amount of data needs to be written into the SSD every day, the SSD with three DWPD may be selected. When a small amount of data needs to be written into the SSD every day, the SSD with one DWPD may be selected. However, during actual application, a service involved in the scenario may change with time. As a result, a previously selected SSD does not meet a subsequent actual requirement, resulting in a resource shortage or a resource waste. For example, the SSD with one DWPD is previously selected. However, as a subsequent service volume increases, a total amount of data written every day also increases. As a result, the SSD cannot meet a subsequent service requirement. For another example, the SSD with three DWPD is previously selected. However, as a subsequent service volume decreases, a total amount of data written every day also decreases. As a result, a storage resource in the SSD is not fully utilized, resulting in the resource waste.

For the foregoing problem, embodiments of this application provide an adjustment system, to adjust a specification parameter of an SSD based on a future service requirement, further improve utilization of the SSD when the future service requirement is met, and reduce a resource shortage or resource waste.

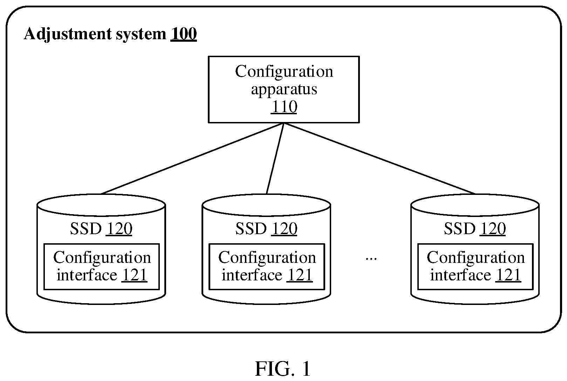

Functions of the adjustment system provided in embodiments of this application may be implemented by a software system, a hardware device, or a combination of the software system and the hardware device. FIG. 1 is an example of a diagram of a structure of the foregoing adjustment system. As shown in FIG. 1, the adjustment system 100 includes a configuration apparatus 110 and at least one SSD 120. The following briefly describes various parts of the adjustment system 100.

The configuration apparatus 110 is configured to: collect running status information of the at least one SSD 120, generate at least one configuration command based on the running status information, and send the at least one configuration command to a corresponding SSD 120. Running status information of each SSD 120 indicates a running status of the SSD 120.

Optionally, the configuration apparatus 110 is further configured to: determine, based on the running status information of the at least one SSD 120, whether a service life of the at least one SSD 120 is exhausted. When a service life of an SSD 120 is exhausted, the configuration apparatus 110 is further configured to notify a user to replace the SSD with a new SSD in time.

Optionally, the configuration apparatus 110 is further configured to determine, based on the running status information of the at least one SSD 120, whether the at least one SSD 120 reaches the service life. It should be understood that, in actual use, the SSD generally does not continue to be used after reaching the service life. This is because if the SSD continues to be used after reaching the service life, performance of the SSD deteriorates, and a data error rate is high. Therefore, when determining that an SSD 120 reaches a service life, the configuration apparatus 110 is further configured to notify the user to replace the SSD with a new SSD in time.

Optionally, after determining that a service life of an SSD 120 is exhausted or the SSD 120 reaches the service life, the configuration apparatus 110 is further configured to: determine whether current data retention of the SSD is less than target data retention, and if the current data retention of the SSD is less than the target data retention, notify the user to store the SSD at a low temperature.

The SSD 120 includes a configuration interface 121, and is configured to: receive, through the configuration interface 121, the configuration command sent by the configuration apparatus 110, and adjust a specification parameter of the SSD 120 based on the configuration command. The specification parameter of the SSD 120 includes at least one of DWPD, data retention, a P/E count (or a PU), and a capacity of OP. The DWPD is a quantity of times of a drive write operation that can be performed on the SSD 120 every day. The data retention is a time period in which the SSD 120 can store data when the SSD 120 is in a power-off state. The P/E count is a quantity of times of a P/E operation that can be performed on the SSD 120. The PU is a ratio of a quantity of times of an erase operation that has been performed on the SSD 120 to a quantity of times of the erase operation that can be performed on the SSD 120.

It should be noted that the quantity of times of the erase operation that can be performed on the SSD 120 in the PU definition is a quantity that is of times of the erase operation that can be supported by the SSD 120 and that is defined by a manufacturer (that is, a P/E count specified by the manufacturer). Generally, after the quantity of times of the P/E operation performed on the SSD 120 reaches the P/E count specified by the manufacturer, it does not mean that the service life of the SSD 120 ends. In other words, after the quantity of times of the P/E operation performed on the SSD 120 reaches the P/E count specified by the manufacturer, the P/E operation may still be performed on the SSD 120. The definition in this concept is different from a definition of the foregoing P/E count in the specification parameter of the SSD 120, and a difference lies in that the foregoing adjustable P/E count is a quantity of times of the P/E operation that can be actually performed on the SSD 120.

It can be learned from the foregoing descriptions that, the adjustment system 100 provided in this embodiment of this application can adjust the specification parameter of the SSD 120. In particular, when a service requirement changes dynamically with time, the adjustment system 100 is used to adjust the specification parameter of the SSD 120, so that the SSD 120 can better meet a change of the service requirement. This improves utilization of the SSD 120, and reduces occurrence of a resource shortage or resource waste.

The adjustment system 100 may be used in a scenario in which the at least one SSD 120 is used as a storage device. The following describes an application scenario of the adjustment system 100 by using several specific examples.

Example 1: The at least one SSD 120 is used as a storage device (for example, a cache or a main memory) in a distributed storage system.

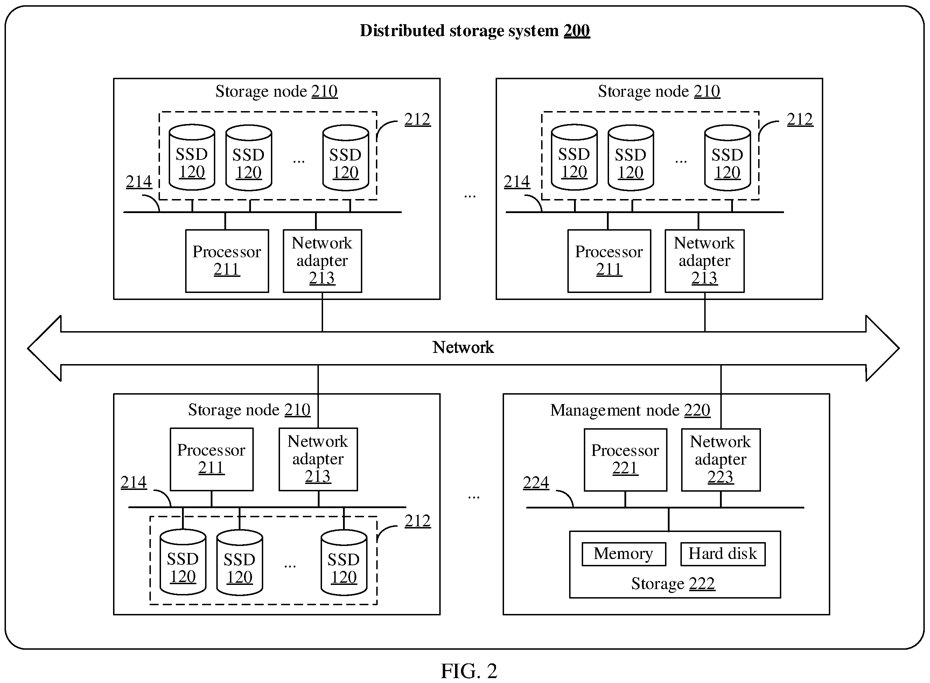

The distributed storage system is a system in which data is stored on a plurality of independent storage nodes in a distributed manner. FIG. 2 is an example of a diagram of a structure of a distributed storage system according to an embodiment of this application. As shown in FIG. 2, the distributed storage system 200 includes at least one storage node 210, and each storage node 210 includes at least a processor 211, a storage 212, a network adapter 213, and a bus 214. The processor 211 may include a central processing unit (central processing unit, CPU), a microprocessor, or the like, and is configured to process a request generated inside the storage node 210 and a data access request from the outside of the storage node 210 (for example, from another storage node). In addition, the processor 211 may be further configured to perform data calculation or processing. The storage 212 is configured to provide a storage resource, may include the SSD 120 shown in FIG. 1, and may further include storage media such as a hard disk drive (hard disk drive, HDD) and a double data rate synchronous dynamic random access memory (double data rate synchronous dynamic random access memory, DDR). The network adapter 213 is configured to provide a network resource, for example, implement communication with a device outside the storage node 210. The bus 214 is configured to connect the processor 211, the storage 212, and the network adapter 213.

The distributed storage system 200 further includes a management node 220. The management node 220 may communicate with each storage node 210, and is configured to manage each storage node 210. The management node 220 includes at least a processor 221, a storage 222, a network adapter 223, and a bus 224. The processor 221 (for example, a CPU) is configured to process a request generated inside the management node 220 and a request from the outside of the management node 220 (for example, from the storage node 210). In addition, the processor 221 may be further configured to perform data calculation or processing. The storage 222 is configured to provide a storage resource, and may include a memory, or may include a storage medium such as a hard disk. The network adapter 223 is configured to provide a network resource, for example, implement communication with the storage node 210. The bus 224 is configured to connect the processor 221, the storage 222, and the network adapter 223.

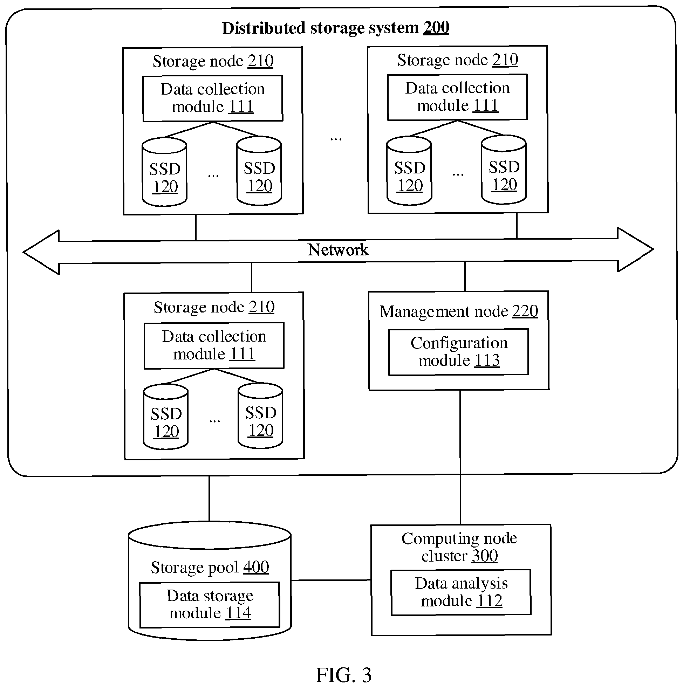

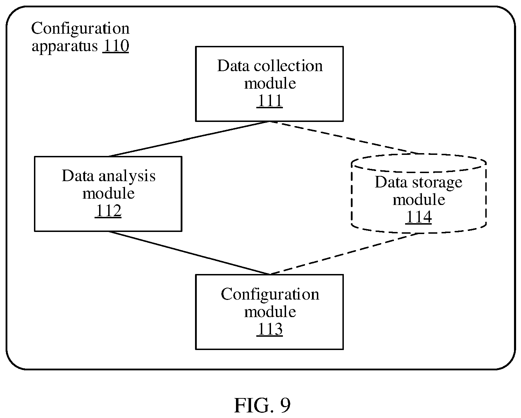

In the foregoing scenario, the adjustment system 100 is flexibly deployed. For example, the adjustment system 100 may be completely deployed in the storage node 210. For another example, the configuration apparatus 110 in the adjustment system 100 is deployed on a device outside the distributed storage system 200, and the at least one SSD 120 in the adjustment system 100 corresponds to an SSD in each storage node 210 in the distributed storage system 200. For another example, the configuration apparatus 110 may be further logically divided into a plurality of parts, and the parts have different functions. In an embodiment (for example, FIG. 9 below), the configuration apparatus 110 may include a data collection module 111, a data analysis module 112, a configuration module 113, and a data storage module 114. In this case, as shown in FIG. 3, the data collection module 111 is deployed inside each storage node 210 in the distributed storage system 200, the data analysis module 112 is deployed on a computing node cluster 300, the configuration module 113 is deployed on the management node 220 in the distributed storage system 200, and the data storage module 114 is deployed on a storage pool 400 (for example, an object storage service (object storage service, OBS)) outside the distributed storage system 200. The at least one SSD 120 in the adjustment system 100 corresponds to an SSD in each storage node 210.

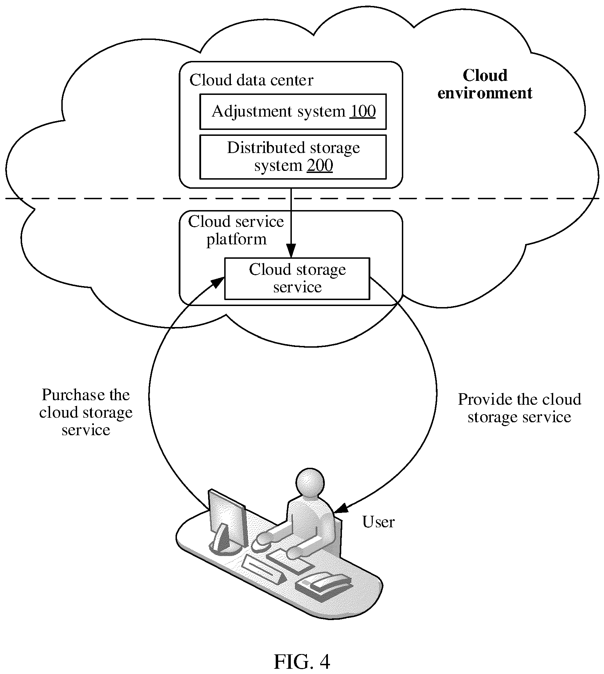

In some embodiments, the adjustment system 100 may be provided by a cloud service provider for the user in a form of a cloud service. As shown in FIG. 4, both the adjustment system 100 and the distributed storage system 200 are deployed in a cloud environment. The cloud environment is an entity that provides the cloud service for the user by using a basic resource in a cloud computing mode. The cloud environment includes a cloud data center and a cloud service platform. The cloud data center includes a large quantity of basic resources (including a computing resource, a storage resource, and a network resource) owned by the cloud service provider. The adjustment system 100 and the distributed storage system 200 in the cloud environment cooperate to provide a cloud storage service for the user. Specifically, after the user purchases the cloud storage service on the cloud service platform (where pre-recharging may be performed, and then settlement can be performed based on final resource usage), the cloud environment provides the cloud storage service for the user by using the adjustment system 100 and the distributed storage system 200 that are deployed in the cloud data center. When using the cloud storage service, the user uploads to-be-stored data to the distributed storage system 200, and the distributed storage system 200 stores the data in the at least one SSD 120. In addition, the adjustment system 100 further collects the running status information of the SSD 120, and determines a future service requirement for a specification parameter of the at least one SSD 120 based on the running status information, to adjust the specification parameter of the at least one SSD 120 in time, improve resource utilization of the at least one SSD 120, so that the at least one SSD 120 can meet the future service requirement.

In some other embodiments, cloud services provided by the adjustment system 100 and the distributed storage system 200 in the cloud environment for the user may be divided into two parts: a basic cloud storage service and an optimized cloud storage service. The basic cloud storage service is used to provide a data storage service for the user, and the distributed storage system 200 provides the data storage service for the user. The optimized cloud storage service is used to provide a service for adjusting the specification parameter of the SSD for the user, and the adjustment system 100 provides the service for the user. On a cloud service platform, the user may first purchase only the basic cloud storage service and then purchase the optimized cloud storage service when needing to use the optimized cloud storage service.

Example 2: The at least one SSD 120 is used as a storage device (for example, a cache or a main memory) in a centralized storage system.

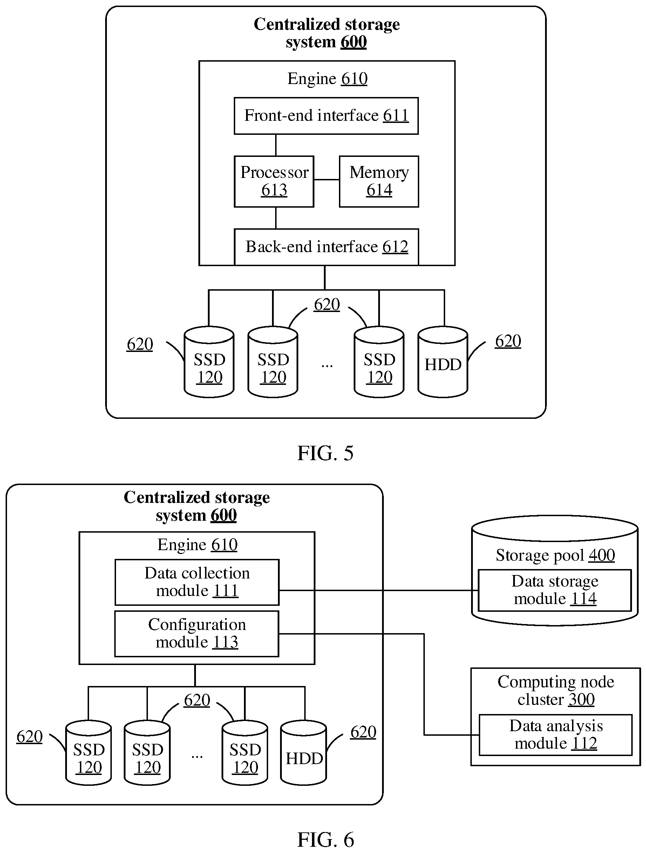

The centralized storage system means a central node including one or more host devices. Data is stored on the central node in a centralized manner, and all data processing services of the entire system are deployed on the central node in a centralized manner. In other words, in the centralized storage system, a terminal or a client is only responsible for data input and output, and data storage processing and data control processing are completely completed by the central node. FIG. 5 is an example of a diagram of a structure a centralized storage system according to an embodiment of this application. As shown in FIG. 5, the centralized storage system 600 includes an engine 610 and at least one hard disk 620. The engine 610 is a core component in the centralized storage system 600. The engine 610 includes a front-end interface 611 and a back-end interface 612. The front-end interface 611 is configured to communicate with a device outside the centralized storage system 600. For example, the front-end interface 611 may communicate with an application server, where an application program runs on the application server, and the user can access data by using the application program. The back-end interface 612 is configured to communicate with the at least one hard disk 620, to access data from the at least one hard disk 620. The hard disk 620 is configured to provide a storage resource, and may include a storage device such as an SSD (for example, the foregoing at least one SSD 120) or an HDD.

The engine 610 further includes a processor 613 and a memory 614. The processor 613 (for example, a CPU) is configured to process a request generated inside the centralized storage system 600 and a data access request from the outside of the system, and is further configured to perform data calculation or processing. The memory 614 is an internal storage that directly exchanges data with the processor 613, for example, a read-only memory (read-only memory, ROM) or a random access memory (random access memory, RAM). The memory 614 can read and write data at a high speed at any time, and can be used as a temporary data storage of an operating system or another running program.

In the foregoing scenario, the adjustment system 100 is flexibly deployed. For example, the adjustment system 100 may be completely deployed in the centralized storage system 600. For another example, the configuration apparatus 110 in the adjustment system 100 is deployed on the device outside the centralized storage system 600, and the at least one SSD 120 in the adjustment system 100 corresponds to the at least one SSD in the centralized storage system 600. For another example, as shown in FIG. 6, a data collection module 111 and a configuration module 113 are deployed on the engine 610 in the centralized storage system 600, a data analysis module 112 is deployed on a computing node cluster 300, and a data storage module 114 is deployed on a storage pool 400 (for example, an OBS). The at least one SSD 120 in the adjustment system 100 corresponds to the at least one SSD in the centralized storage system 600. For example, the adjustment system 100 may be provided by a cloud service provider for the user in a form of a cloud service. For a specific implementation, refer to FIG. 4 and related descriptions thereof.

Example 3: The at least one SSD 120 is used as a storage device in a server.

It should be noted that the server herein may include a physical machine (for example, a desktop computer, a notebook computer, or a mobile device), or may include a virtual machine, and may support direct access and control of the user. An SSD (including the at least one SSD 120 in the adjustment system 100) is configured on the server. For example, the server may be a bare metal server (bare metal server, BMS), is a dedicated server provided by a cloud service provider for the user, and has many advantages such as security isolation, high reliability, high computing performance, high stability, and high real-time performance.

In some embodiments, the configuration apparatus 110 in the adjustment system 100 may be deployed on the server. Alternatively, a part of the configuration apparatus 110 in the adjustment system 100 is deployed on the server, and a part of the configuration apparatus 110 in the adjustment system 100 is deployed on another device. For example, a data collection module 111 and a configuration module 113 are deployed on the server, a data analysis module 112 is deployed on a computing node cluster 300, and a data storage module 114 is deployed on a storage pool 400. For another example, a data collection module 111, a data analysis module 112, and a configuration module 113 are deployed on the server, and a data storage module 114 is deployed on a storage pool 400. Alternatively, the configuration apparatus 110 is completely deployed on another device. Based on the adjustment system 100, a specification parameter of the at least one SSD 120 deployed on the server may be adjusted based on the service requirement. In addition, because the server supports direct access and control of the user, the specification parameter of the at least one SSD 120 deployed on the server may further be configured by the user.

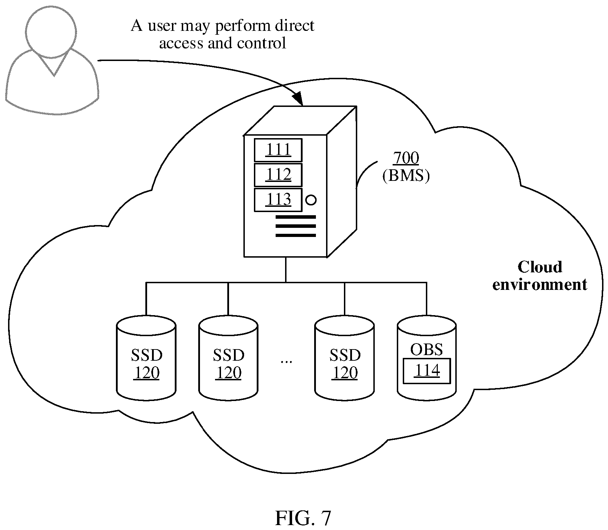

In a scenario shown in FIG. 7, a plurality of SSDs 120 and an OBS are mounted on a BMS 700, to provide a data storage service for the BMS 700. A data collection module 111, a data analysis module 112, and a configuration module 113 are further deployed on the BMS 700, and a data storage module 114 is deployed on the OBS. For example, the BMS 700 executes a service (for example, an internet big data service or an artificial intelligence service), and sends, to the plurality of SSDs 120 for persistent storage, a large amount of data generated in a service execution process. Then, specification parameters of the plurality of SSDs 120 are adjusted based on functions of the data collection module 111, the data analysis module 112, and the configuration module 113 that are deployed on the BMS 700, and a function of the data storage module 114 deployed on the OBS. In addition, because the BMS 700 supports access and control of the user, the user may further configure the specification parameters of the plurality of SSDs 120 by using the configuration module 113, so that a better service is provided for the user.

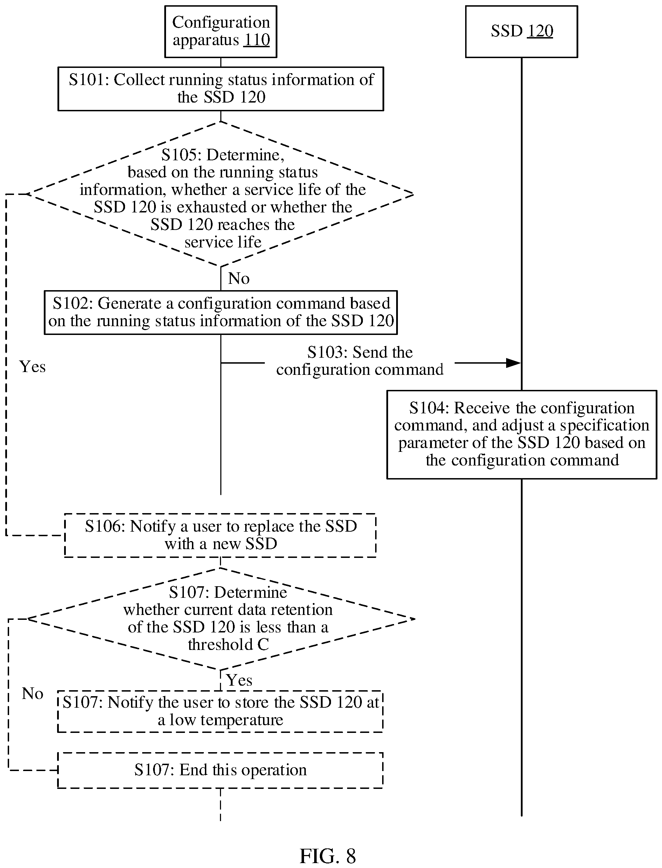

The following further describes the foregoing adjustment system 100 based on a method for adjusting a specification parameter of an SSD that is described in FIG. 8. It should be noted that, for simplicity, an example in which a specification parameter of an SSD 120 is adjusted is used herein for detailed description.

S101: A configuration apparatus 110 collects running status information of the SSD 120.

The running status information of the SSD 120 indicates a running status of the SSD 120. Optionally, the running status information of the SSD 120 includes at least one of a write bandwidth, an available capacity, a power-on time period, a PU, a frequency of data erasing, and a disk identifier. The write bandwidth of the SSD 120 is an amount of data written into the SSD 120 per unit time. The available capacity of the SSD 120 is a capacity occupied by storage space that can be used by a user in the SSD 120. The power-on time period of the SSD 120 is duration in which the SSD 120 is in a power-on state. The disk identifier identifies the SSD 120, and may be specifically a number of the SSD 120, ID information of the SSD 120, or the like.

In addition to the foregoing parameters, the running status information of the SSD 120 may further include a plurality of other parameters, for example, a read bandwidth, a total capacity, and a disk temperature. The read bandwidth of the SSD 120 indicates an amount of data read from the SSD 120 per unit time. The total capacity of the SSD 120 is a sum of the available capacity of the SSD 120 and a capacity of OP. The capacity of the OP is a capacity occupied by the OP in the SSD 120. The OP is storage space unavailable to the user, and is used by the SSD 120 to perform an operation such as garbage collection. The disk temperature is a temperature of the SSD 120.

In some embodiments, the configuration apparatus 110 may collect the running status information of the SSD 120 periodically (for example, every other day) or at a preset time point. In this case, the running status information of the SSD 120 collected by the configuration apparatus 110 can indicate a running status of the SSD 120 at least one moment (including a current moment and a historical moment), and may specifically include: at least one write bandwidth, at least one available capacity, at least one power-on time period, at least one PU, at least one frequency of the data erasing, and the like. In this way, the configuration apparatus 110 can more accurately predict a future service requirement for the specification parameter of the SSD 120, so that an adjusted SSD 120 better meets the future service requirement.

S102: The configuration apparatus 110 generates a configuration command based on the running status information of the SSD 120. A current specification parameter of the SSD 120 is a first specification parameter, and the configuration command includes representation information of a second specification parameter.

In some embodiments, that the configuration apparatus 110 generates a configuration command based on the running status information of the SSD 120 includes: The configuration apparatus determines the future service requirement for the specification parameter of the SSD 120 based on the running status information of the SSD 120, and then generates the configuration command based on the future service requirement for the specification parameter of the SSD 120.

Further, that the configuration apparatus 110 determines the future service requirement for the specification parameter of the SSD 120 based on the running status information of the SSD 120 includes the following several cases.

Case 1: The configuration apparatus 110 determines a future service requirement for DWPD of the SSD 120 based on the collected at least one write bandwidth, at least one available capacity, and at least one power-on time period.

Specifically, the configuration apparatus 110 calculates at least one written data amount based on the collected at least one write bandwidth and at least one power-on time period, where each written data amount indicates an amount of data written into the SSD 120 every day in the past. Then, the configuration apparatus 110 separately calculates a ratio of the at least one written data amount to a corresponding available capacity, to obtain at least one value of DWPD, and predicts the future service requirement for the DWPD of the SSD 120 based on the at least one value of DWPD. The configuration apparatus 110 may use an algorithm (for example, a moving average algorithm, a function fitting algorithm, or a machine learning algorithm) to process the at least one value of DWPD, to predict the future service requirement for the DWPD of the SSD 120.

Case 2: The configuration apparatus 110 determines a future service requirement for data retention of the SSD 120 based on the collected at least one frequency of the data erasing.

It should be understood that the SSD erases data when the data does not need to be stored. Therefore, a time period in which the SSD needs to store the data may be determined by analyzing a frequency of data erasing of the SSD. In this case, that the configuration apparatus 110 determines the future service requirement for data retention of the SSD 120 based on the collected at least one frequency of the data erasing includes: The configuration apparatus 110 predicts, based on the collected at least one frequency of the data erasing, a frequency of the data erasing of the SSD 120 in the future, and then determines, based on the frequency of the data erasing of the SSD 120 in the future, the future service requirement for the data retention of the SSD 120.

Optionally, the configuration apparatus 110 may further determine the future service requirement for the data retention time of the SSD 120 with reference to a frequency of moving data by an application program from the SSD 120. It should be understood that the data moved out of the SSD 120 by the application program is erased by the SSD 120, that is, this part of the data does not need to be further stored by the SSD 120. Therefore, similar to the foregoing case in which the future service requirement for the data retention of the SSD 120 can be determined based on the collected frequency of the data erasing, the future service requirement for the data retention of the SSD 120 may also be determined based on the frequency of moving the data by the application program from the SSD 120. In addition, the frequency of moving the data by the application program from the SSD 120 may be provided by the application program for the configuration apparatus 110, or may be provided by the SSD 120 for the configuration apparatus 110. This is not specifically limited herein.

Case 3: The configuration apparatus 110 determines a future service requirement for a P/E count (or a PU) of the SSD 120 based on the collected at least one PU.

Specifically, the configuration apparatus 110 calculates, based on the collected at least one PU and a P/E count specified by a manufacturer, a quantity of times of a P/E operation that can be actually performed on the SSD 120 in a past time period, to predict the future service requirement for the P/E count. Alternatively, the configuration apparatus 110 uses an algorithm (for example, a moving average algorithm, a function fitting algorithm, or a machine learning algorithm) to process the collected at least one PU, to predict the future service requirement for the PU.

In a possible implementation, a level table is configured in the configuration apparatus 110, the level table includes a plurality of levels, and each level includes a correspondence between at least two parameters of the DWPD, the data retention, the P/E count, and the PU of the SSD 120. Table 1 shows an example of a level table provided in this embodiment of this application.

**Table 1**

| Level | DWPD | Data retention | P/E count |
|---|---|---|---|
| 1 | DWPD₁ | T₁ | P/E₁ |
| 2 | DWPD₂ | T₂ | P/E₂ |
| ... | ... | ... | ... |
| *m* | DWPD*ₘ* | T*ₘ* | P/E*ₘ* |

Table 1 includes *m* values of DWPD, *m* pieces of data retention, and *m* P/E counts. These parameters correspond to *m* levels (where *m* is a positive integer greater than 0). Each level indicates a correspondence between the DWPD, the data retention, and the P/E count of the SSD 120. Specifically, in the level 1, there is a correspondence between DWPD₁, T₁, and P/E₁; in the level 2, there is a correspondence between DWPD₂, T₂, and P/E₂; ...; and in the level *m*, there is a correspondence between DWPD*ₘ*, T*ₘ*, and P/E*ₘ*.

The foregoing level table may be flexibly set based on a real scenario (where for example, the SSD 120 is used as a storage device in a distributed storage system 200, a centralized storage system 600, or a BMS 700) in which the SSD 120 may run. For example, the real scenario in which the SSD 120 runs is simulated, to enable the SSD 120 to run in the simulated scenario. The data retention of the SSD 120 is controlled to be T₁, P/E is controlled to be P/E₁, and the DWPD of the SSD 120 is controlled to be continuously increased. In addition, data error rates of the SSD 120 in different DWPD are tested until the data error rate is greater than a threshold B. In this case, a previous value of DWPD (namely, DWPD₁) is recorded, and DWPD₁, T₁, and P/E₁ are recorded as one level (namely, the level 1). By analogy, the level table shown in Table 1 is obtained.

Optionally, the representation information of the second specification parameter includes a target level (in other words, the configuration command includes the target level), and the target level is any one of the plurality of levels in the level table. In other words, the second specification parameter includes a specification parameter corresponding to the target level. In this case, that the configuration apparatus 110 generates the configuration command based on the future service requirement for the specification parameter of the SSD 120 includes: The configuration apparatus 110 determines the target level from the plurality of levels in the level table based on the future service requirement for the specification parameter of the SSD 120, and then generates the configuration command based on the target level.

Further, the configuration apparatus 110 may determine a future service requirement for a specification parameter based on the running status information of the SSD 120, and then may generate a configuration command by querying the foregoing level table. For example, it is assumed that the configuration apparatus 110 determines that the future service requirement for the DWPD of the SSD 120 is that the value of DWPD is greater than 1. *m* in the level table shown in Table 1 is 3, a value of DWPD₁ is equal to 1, a value of DWPD₂ is equal to 2, and a value of DWPD₃ is equal to 3. The level table is queried, so that it can be determined that the level 2 and the level 3 meet the foregoing requirement that the value of DWPD is greater than 1. Then, whether the data retention T₂ and T₃ in the level 2 and the level 3 meet the future service requirement for the data retention are separately determined. Assuming that T₂ meets the requirement and T₃ does not meet the requirement, the configuration apparatus 110 determines that the level 2 is the target level, and generates the configuration command based on the level 2. In this way, a rate at which the configuration apparatus 110 generates the configuration command can be increased, and efficiency of adjusting the specification parameter of the SSD 120 by the adjustment system 100 can be further improved.

In consideration of actual application, there may be at least two levels in the level table meeting the future service requirement. In this case, the configuration apparatus 110 determines a level corresponding to maximum DWPD as the target level.

Further, the configuration apparatus 110 may perform the following step: reducing a capacity of current OP in the SSD 120 based on the maximum DWPD, to obtain the capacity of the target OP. In this way, the available capacity of the SSD 120 can be increased, and utilization of the SSD 120 can be improved. Especially when a future service requirement for storage space of the SSD 120 increases, costs can be reduced by using the foregoing steps.

It should be noted that, it can be learned from a feature of the SSD that when the capacity of the OP of the SSD is reduced, the DWPD of the SSD is also correspondingly reduced. In other words, after the capacity of the OP of the SSD is reduced, a quantity of times of a drive data write operation that can be performed on the SSD every day needs to be reduced. Otherwise, a service life of the SSD is shortened. Therefore, it should be ensured that DWPD of the SSD 120 after the capacity of the OP is reduced can still meet the future service requirement. For example, it is assumed that the configuration apparatus 110 determines that the future service requirement for the DWPD of the SSD 120 is that the DWPD is greater than 1. In the level table shown in Table 1, *m* is 3, DWPD₁ is equal to 1, DWPD₂ is equal to 2, and DWPD₃ is equal to 3. The level table is queried, so that it can be determined that the three types of specification parameters in the level 2 and the level 3 all meet the future service requirement. In this case, the configuration apparatus 110 may select the level 3 as the target level, and then reduce the capacity of the current OP of the SSD 120 as much as possible. The capacity of the target OP is obtained through calculation. Correspondingly, the DWPD decreases accordingly but is still greater than 1, and it indicates that the capacity of the target OP can meet the future service requirement (including the future service requirement for the DWPD of the SSD 120).

Further, the representation information of the second specification parameter may include the capacity of the target OP (that is, the configuration command may include the capacity of the target OP), and that the configuration apparatus 110 generates the configuration command based on the target level includes: The configuration apparatus 110 generates the configuration command based on the target level and the capacity of the target OP.

In some other embodiments, the configuration command may alternatively be generated by the configuration apparatus 110 based on a requirement that is entered by the user and that is for the specification parameter of the SSD 120. For example, the configuration apparatus 110 provides a user interface (user interface, UI), and the foregoing level table is displayed on the UI. The user selects a proper level (namely, the target level) based on a requirement of the user, and sends information about the selected level to the configuration apparatus 110 through the UI. In this way, the configuration apparatus 110 can generate the configuration command.

S103: The configuration apparatus 110 sends the configuration command to the SSD 120.

Specifically, the configuration apparatus 110 sends the configuration command to a configuration interface 121 of the SSD 120 based on the disk identifier of the SSD 120.

S104: The SSD 120 receives the configuration command, and adjusts the specification parameter of the SSD 120 based on the configuration command.

Specifically, the SSD 120 receives, through the configuration interface 121, the configuration command sent by the configuration apparatus 110, and adjusts the specification parameter of the SSD 120 from the first specification parameter to the second specification parameter based on the configuration command, so that the adjusted SSD 120 meets the future service requirement.

Optionally, the SSD 120 also includes the foregoing level table, and the configuration command includes the target level. In this case, that the SSD 120 adjusts the specification parameter of the SSD 120 from the first specification parameter to the second specification parameter based on the configuration command includes: The SSD 120 obtains the target level by parsing the configuration command, then matches the target level with the plurality of levels in the level table, and determines the specification parameter corresponding to the target level, to adjust the specification parameter of the SSD 120 from the first specification parameter to the specification parameter corresponding to the target level.

Optionally, the configuration command includes the capacity of the target OP. In this case, that the SSD 120 adjusts the specification parameter of the SSD 120 from the first specification parameter to the second specification parameter based on the configuration command includes: The SSD 120 obtains the capacity of the target OP by parsing the configuration command, and then adjusts the capacity of the OP in the first specification parameter to the capacity of the target OP.

In consideration of actual application, the SSD 120 is a loss type device. Therefore, optionally, the configuration apparatus 110 may further perform one or more of the following steps.

S105: The configuration apparatus 110 determines, based on the running status information of the SSD 120, whether the service life of the SSD 120 is exhausted or whether the SSD 120 reaches the service life, and performs S106 and S107 if the service life of the SSD 120 is exhausted or the SSD 120 reaches the service life; or performs S102 to S103 if the service life of the SSD 120 is not exhausted and the SSD 120 does not reach the service life.

S106: The configuration apparatus 110 notifies the user to replace the SSD with a new SSD.

S107: The configuration apparatus 110 determines whether current data retention of the SSD 120 is less than a threshold C, and if the current data retention is less than or equal to the threshold C, notifies the user to store the SSD 120 at a low temperature; or if the current data retention is greater than the threshold C, ends this operation.

The threshold C is a storage time period needed by the data in the SSD 120. The time period may be preset by the user, or may be dynamically adjusted by the configuration apparatus 110 based on an actual situation. This is not limited herein.

The foregoing describes in detail the adjustment method provided in embodiments of this application with reference to FIG. 8. The following describes in more detail an adjustment system 100 in terms of a structure of the adjustment system 100 with reference to FIG. 9 to FIG. 11.

FIG. 9 is an example of a diagram of a structure of a configuration apparatus 110 inside an adjustment system 100. As shown in FIG. 9, the configuration apparatus 110 includes a data collection module 111, a data analysis module 112, and a configuration module 113. The data collection module 111, the data analysis module 112, and the configuration module 113 cooperate to implement the steps performed by the configuration apparatus 110 in the foregoing method embodiments. Specifically, the data collection module 111 is configured to perform S 101; the data analysis module 112 is configured to perform the steps of determining whether the current data retention of the SSD 120 is greater than the threshold C in S102, S105, and S107; and the configuration module 113 is configured to perform the steps of notifying the user to store the SSD 120 at the low temperature in S103, S106, and S107.

Optionally, the configuration apparatus 110 further includes a data storage module 114. The data storage module 114 is configured to store running status information that is of at least one SSD 120 and that is collected by the data collection module 111, and is further configured to send the collected running status information to the data analysis module 112, so that the data analysis module 112 generates a configuration command.

It should be understood that the diagram of the structure shown in FIG. 9 is merely an example of a structural division manner in which the configuration apparatus 110 is divided based on functions. A specific structural division manner of the configuration apparatus 110 is not limited in embodiments of this application. It should be further understood that modules inside the configuration apparatus 110 may be software modules, or hardware modules, or some may be software modules and some may be hardware modules.

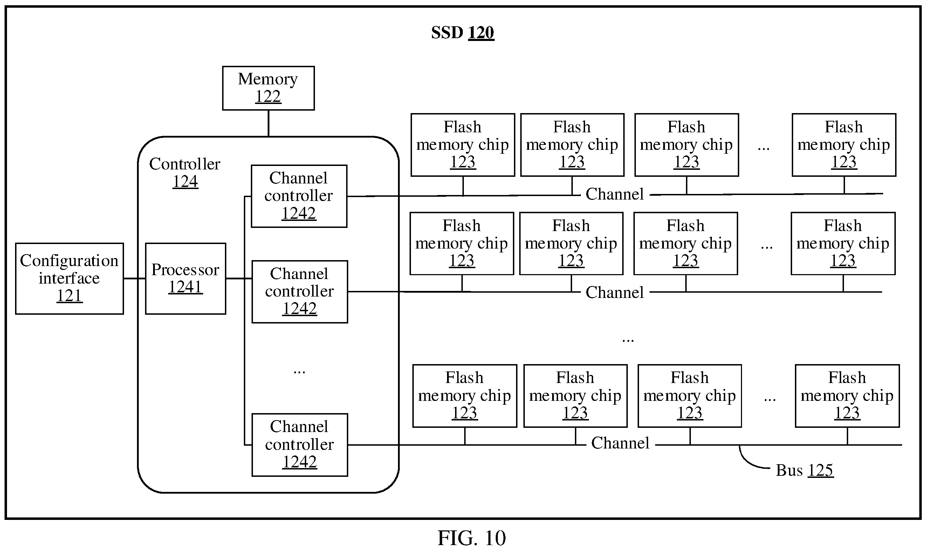

FIG. 10 is an example of a diagram of a structure of an SSD 120 inside an adjustment system 100. As shown in FIG. 10, the SSD 120 includes a configuration interface 121, a memory 122, a plurality of flash memory chips 123, a controller 124, and a bus 125.

The configuration interface 121 is configured to receive a configuration command. For detailed descriptions of the configuration command, refer to the foregoing method embodiments. Details are not described herein again.

The memory 122 is configured to store program code. When the program code is executed by the controller 124, some or all of the steps described in S104 may be implemented.

The plurality of flash memory chips 123 are configured to store data.

The controller 124 (which may also be referred to as a main controller 124) is equivalent to a brain center of the SSD 120, and may be specifically an embedded microchip. The controller 124 includes a processor 1241. A function of the processor 1241 is like a command center, and the processor 1241 is configured to send all operation requests of the SSD 120. For example, the processor 1241 is configured to: execute the program code in the memory, to implement functions such as data storage management, maintaining performance of the SSD 120, and adjusting a specification parameter of the SSD 120 based on the configuration command.

The controller 124 further includes a plurality of channel controllers 1242. The plurality of channel controllers 1242 are used, so that the controller 124 can operate the plurality of flash memory chips 123 in parallel, to increase a bandwidth (including a write bandwidth and a read bandwidth) at a bottom layer of the SSD 120.

The bus 125 may include a path for transmitting information between various components (for example, the configuration interface 121, the memory 122, the plurality of flash memory chips 123, and the controller 124) in the SSD 120, and is configured to implement communication connections between the configuration interface 121, the memory 122, the plurality of flash memory chips 123, and the controller 124.

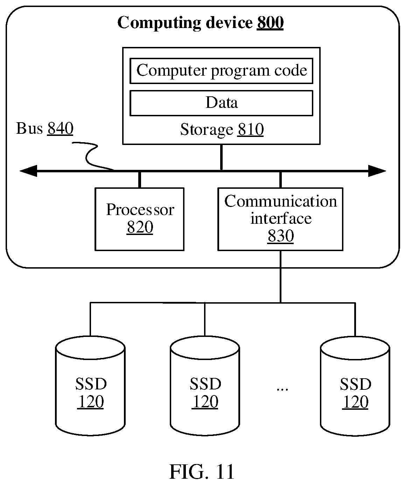

FIG. 11 is a diagram of a structure of a computing device according to an embodiment of this application. The configuration apparatus 110 in the foregoing adjustment system 100 may be deployed on the computing device, and the at least one SSD 120 in the foregoing adjustment system 100 may be connected to the computing device, to implement a function of the adjustment system 100. As shown in FIG. 11, the computing device 800 includes a storage 810, a processor 820, a communication interface 830, and a bus 840. The storage 810, the processor 820, and the communication interface 830 implement communication connections between each other through the bus 840.

The storage 810 may include a ROM, a RAM, a static storage device, a dynamic storage device, a hard disk (for example, an SSD or an HDD), and the like. The storage 810 may store program code, for example, program code in a data collection module 111, program code in a data analysis module 112, program code in a configuration module 113, and program code in a data storage module 114. When the program code stored in the storage 810 is executed by the processor 820, the processor 820 and the communication interface 830 are configured to perform some or all methods (including S101 to S103 and S105 to S107) performed by the configuration apparatus 110. The storage 810 may further store data, for example, intermediate data or result data generated by the processor 820 in an execution process, for example, running status information or a configuration command of the at least one SSD 120.

The processor 820 may be a CPU, an application-specific integrated circuit (application-specific integrated circuit, ASIC), a graphics processing unit (graphics processing unit, GPU), or one or more integrated circuits.

The processor 820 may alternatively be an integrated circuit chip and has a signal processing capability. In an implementation process, some functions of the configuration apparatus 110 may be implemented by using an integrated logic circuit of hardware or instructions in a form of software in the processor 820. The processor 820 may alternatively be a general purpose processor, a digital signal processor (digital signal processor, DSP), a field programmable gate array (field programmable gate array, FPGA), or another programmable logic device, a discrete gate or a transistor logic device, or a discrete hardware component, and may implement or perform the methods, steps, and logical block diagrams disclosed in embodiments of this application. The general purpose processor may be a microprocessor, or the processor may be any conventional processor, or the like. The methods disclosed with reference to embodiments of this application may be directly performed and completed by a hardware decoding processor, or may be performed and completed by a combination of hardware and a software module in the decoding processor. The software module may be located in a mature storage medium in the art, such as a random access memory, a flash memory, a read-only memory, a programmable read-only memory, an electrically erasable programmable memory, or a register. The storage medium is located in the storage 810, and the processor 820 reads information in the storage 810, and completes some or all functions of the configuration apparatus 110 in combination with hardware of the processor 820.

The communication interface 830 uses a transceiver module, for example, but not limited to a transceiver, to implement communication between the computing device 800 and another device or a communication network. For example, the at least one SSD 120 is connected through the communication interface 830, and when it is determined that a service life of the SSD 120 is exhausted or the SSD 120 reaches the service life, a user is notified, through the communication interface 830, to replace the SSD with a new SSD.

The bus 840 may include a path for transmitting information between various components (for example, the storage 810, the processor 820, and the communication interface 830) of the computing device 800.

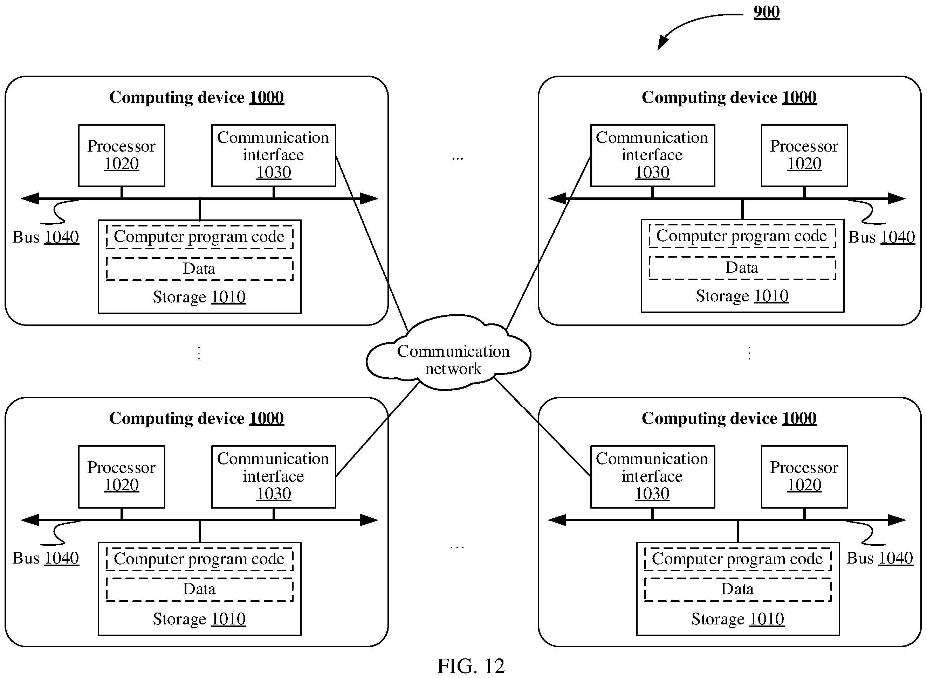

FIG. 12 is a diagram of a structure of a computing device system according to an embodiment of this application. The configuration apparatus 110 in the foregoing adjustment system 100 may be deployed on the computing device system, and the at least one SSD 120 in the foregoing adjustment system 100 may be connected to the computing device system, to implement a function of the adjustment system 100. As shown in FIG. 12, a computing device system 900 includes a plurality of computing devices 1000, and each computing device 1000 includes a storage 1010, a processor 1020, a communication interface 1030, and a bus 1040. The storage 1010, the processor 1020, and the communication interface 1030 implement communication connections between each other through the bus 1040.

The storage 1010 may include a ROM, a RAM, a static storage device, a dynamic storage device, a hard disk (for example, an SSD or an HDD), and the like. The storage 1010 may store program code, for example, a part of program code in a data collection module 111, a part of program code in a data analysis module 112, a part of program code in a configuration module 113, and a part of program code in a data storage module 114. When the program code stored in the storage 1010 is executed by the processor 1020, the processor 1020 and the communication interface 1030 are configured to perform some methods (including some methods described in S101 to S103 and S105 to S107) performed by the configuration apparatus 110. The storage 1010 may further store data, for example, intermediate data or result data generated by the processor 1020 in an execution process, for example, running status information, a level table, or a configuration command of the at least one SSD 120.

The processor 1020 may be a CPU, a GPU, an ASIC, or one or more integrated circuits. The processor 1020 may alternatively be an integrated circuit chip and has a signal processing capability. In an implementation process, some functions of the configuration apparatus 110 may be implemented by using an integrated logic circuit of hardware or instructions in a form of software in the processor 1020. The processor 1020 may alternatively be a DSP, an FPGA, a general purpose processor, another programmable logic device, a discrete gate or a transistor logic device, or a discrete hardware component, and may implement or perform the methods, steps, and logical block diagrams disclosed in embodiments of this application. The general purpose processor may be a microprocessor, or the processor may be any conventional processor, or the like. The steps of the methods disclosed with reference to embodiments of this application may be directly performed and completed by a hardware decoding processor, or may be performed and completed by a combination of hardware and a software module in the decoding processor. The software module may be located in a mature storage medium in the art, such as a random access memory, a flash memory, a read-only memory, a programmable read-only memory, an electrically erasable programmable memory, or a register. The storage medium is located in the storage 1010, and the processor 1020 reads information in the storage 1010, and completes some functions of the configuration apparatus 110 in combination with hardware of the processor 1020.

The communication interface 1030 uses a transceiver module, for example, but not limited to a transceiver, to implement communication between the computing device 1000 and another computing device or a communication network. For example, the at least one SSD 120 is connected through the communication interface 1030, or the running status information of the at least one SSD 120 is collected through the communication interface 1030.

The bus 1040 may include a path for transmitting information between various components (for example, the storage 1010, the processor 1020, and the communication interface 1030) of the computing device 1000.

A communication path is established between the plurality of computing devices 1000 by using a communication network, to implement the function of the configuration apparatus 110. Any computing device may be a computing device (for example, a server) in a cloud environment, a computing device in an edge environment, or a terminal computing device. The edge environment is a set of edge data centers or edge computing devices (for example, an edge server) that are close to the terminal computing device. Terminal computing devices include a terminal server, a smartphone, a notebook computer, a tablet computer, a personal desktop computer, and the like.

The descriptions of the procedures corresponding to the accompanying drawings have respective focuses. For a part that is not described in detail in a procedure, refer to related descriptions of another procedure.

All or some of the foregoing embodiments may be implemented by using software, hardware, or a combination thereof. When the software is used for implementation, all or some of embodiments may be implemented in a form of a computer program product. Computer program products that provide the configuration apparatus 110, the SSD 120, or the adjustment system 100 respectively include one or more pieces of computer program code executed by the configuration apparatus 110, one or more pieces of computer program code executed by the SSD 120, and one or more pieces of computer program code executed by the adjustment system 100. When the computer program code is loaded and executed on a computer, all or some of the procedures or functions according to embodiments of this application are generated.

The computer may be a general-purpose computer, a dedicated computer, a computer network, or another programmable apparatus. The computer program code may be stored in a computer-readable storage medium, or may be transmitted from a computer-readable storage medium to another computer-readable storage medium. For example, the computer program code may be transmitted from a website, computer, server, or data center to another website, computer, server, or data center in a wired (for example, a coaxial cable, an optical fiber, or a twisted pair) or wireless (for example, infrared, radio, or microwave) manner. The computer-readable storage medium stores computer program code that provides the configuration apparatus 110, the SSD 120, or the adjustment system 100. The computer-readable storage medium may be any usable medium that can be accessed by a computer, or a data storage device that is integrated by one or more media, such as a server or a data center. The usable medium may be a magnetic medium (for example, a floppy disk, a hard disk, or a magnetic tape), an optical medium (for example, a compact disk), or a semiconductor medium (for example, a solid-state drive (solid-state drive, SSD)).

## Claims

1. A method for generating a specification parameter of a solid-state drive SSD, comprising:
collecting, by a configuration apparatus, running status information of the SSD, wherein the running status information indicates a running status of the SSD, and a current specification parameter of the SSD is a first specification parameter;
generating, by the configuration apparatus, a configuration command based on the running status information, wherein the configuration command comprises representation information of a second specification parameter; and
sending, by the configuration apparatus, the configuration command to the SSD.

2. The method according to claim 1, wherein the specification parameter of the SSD comprises at least one of drive writes per day DWPD, data retention, a program/erase P/E count, and a capacity of over provisioning OP.

3. The method according to claim 2, wherein the generating, by the configuration apparatus, a configuration command based on the running status information comprises:
determining, by the configuration apparatus, a future service requirement for the specification parameter of the SSD based on the running status information; and
generating, by the configuration apparatus, the configuration command based on the future service requirement for the specification parameter of the SSD, wherein the second specification parameter meets the future service requirement.

4. The method according to claim 3, wherein the configuration apparatus comprises a plurality of levels, and each level comprises a correspondence between at least two parameters of the DWPD, the data retention, and the P/E count.

5. The method according to claim 4, wherein the representation information of the second specification parameter comprises a target level, and the generating, by the configuration apparatus, the configuration command based on the future service requirement for the specification parameter of the SSD comprises:
determining, by the configuration apparatus, the target level from the plurality of levels based on the future service requirement for the specification parameter of the SSD; and
generating, by the configuration apparatus, the configuration command based on the target level.

6. The method according to claim 5, wherein the representation information of the second specification parameter further comprises a capacity of target OP;
the determining, by the configuration apparatus, the target level from the plurality of levels based on the future service requirement for the specification parameter of the SSD comprises:
determining, by the configuration apparatus based on the future service requirement for the specification parameter of the SSD, that at least two levels meet the future service requirement; and
determining, by the configuration apparatus, that a level corresponding to maximum DWPD is the target level;
the method further comprises:
reducing, by the configuration apparatus, a capacity of current OP in the SSD based on the maximum DWPD, to obtain the capacity of the target OP; and
the generating, by the configuration apparatus, the configuration command based on the target level comprises:
generating, by the configuration apparatus, the configuration command based on the target level and the capacity of the target OP.

7. A method for adjusting a specification parameter of a solid-state drive SSD, wherein a current specification parameter of the SSD is a first specification parameter, and the method comprises:
receiving, by the SSD, a configuration command through an internal configuration interface, wherein the configuration command comprises representation information of a second specification parameter; and
adjusting, by the SSD, the specification parameter of the SSD from the first specification parameter to the second specification parameter based on the configuration command.

8. The method according to claim 7, wherein the specification parameter of the SSD comprises at least one of drive writes per day DWPD, data retention, a program/erase P/E count, and a capacity of over provisioning OP.

9. The method according to claim 8, wherein the second specification parameter meets a future service requirement.

10. The method according to claim 9, wherein the SSD stores a plurality of levels, and each level comprises a correspondence between at least two parameters of the DWPD, the data retention, and the P/E count.

11. The method according to claim 10, wherein the representation information of the second specification parameter comprises a target level, and the adjusting, by the SSD, the specification parameter of the SSD from the first specification parameter to the second specification parameter based on the configuration command comprises:
matching, by the SSD, the target level with the plurality of levels, to determine a specification parameter corresponding to the target level, wherein the second specification parameter comprises the specification parameter corresponding to the target level; and
adjusting, by the SSD, the specification parameter of the SSD from the first specification parameter to the specification parameter corresponding to the target level.

12. The method according to claim 10 or 11, wherein the representation information of the second specification parameter comprises a capacity of target OP.

13. A configuration apparatus, comprising:
a data collection module, configured to collect running status information of an SSD, wherein the running status information indicates a running status of the SSD, and a current specification parameter of the SSD is a first specification parameter;
a data analysis module, configured to generate a configuration command based on the running status information, wherein the configuration command comprises representation information of a second specification parameter; and
a configuration module, configured to send the configuration command to the SSD.

14. The apparatus according to claim 13, wherein the specification parameter of the SSD comprises at least one of drive writes per day DWPD, data retention, a program/erase P/E count, and a capacity of over provisioning OP.

15. The apparatus according to claim 14, wherein
the data analysis module is configured to: determine a future service requirement for the specification parameter of the SSD based on the running status information, and generate the configuration command based on the future service requirement for the specification parameter of the SSD, wherein the second specification parameter meets the future service requirement.

16. A solid-state drive SSD, wherein a current specification parameter of the SSD is a first specification parameter, and the SSD comprises:
a configuration interface, configured to receive a configuration command, wherein the configuration command comprises representation information of a second specification parameter; and
a controller, configured to adjust the specification parameter of the SSD from the first specification parameter to the second specification parameter based on the configuration command.

17. The SSD according to claim 16, wherein the specification parameter of the SSD comprises at least one of drive writes per day DWPD, data retention, a program/erase P/E count, and a capacity of over provisioning OP.

18. An adjustment system, comprising the configuration apparatus according to any one of claims 1 to 6 and the SSD according to any one of claims 7 to 12, wherein
the configuration apparatus is configured to: collect running status information of the SSD, generate a configuration command based on the running status information, and send the configuration command to the SSD, wherein the configuration command comprises representation information of a second specification parameter; and
the SSD is configured to: receive the configuration command through an internal configuration interface, and adjust a specification parameter of the SSD from a first specification parameter to the second specification parameter based on the configuration command.

19. A computing device, comprising a processor and a storage, wherein the processor executes computer program code in the storage to implement the method according to any one of claims 1 to 6.

20. A computer-readable storage medium, storing computer program code, wherein when the computer program code is executed by a computing device, the computing device performs the method according to any one of claims 1 to 6.
